# EUROPEAN PATENT SPECIFICATION

(11) **EP 1 666 626 B1**
(45) Date of publication and mention of the grant of the patent: **16.07.2008**
(21) Application number: 05255776.6
(22) Date of filing: 19.09.2005
(51) Int. Cl.: C23C 4/10, C23C 4/18, C23C 30/00, F01D 5/28, C04B 41/50, C04B 41/52, C04B 41/85, C04B 41/89

(54) **Protective coatings**
Schützende Beschichtungen
Revêtements protecteurs

(30) Priority: 19.11.2004 US 992992
(43) Date of publication of application: 07.06.2006
(73) Proprietor: United Technologies Corporation, Hartford, CT 06101 (US)
(72) Inventor: Eaton, Harry E., Woodstock CT 06281 (US); Bhatia, Tania, Middletown CT 06457 (US); Sun, Ellen Y., South Windsor CT 06074 (US); Lawton, Thomas H., Wethersfield CT 06109 (US)
(74) Representative: Power, Philippa Louise

(56) References cited:
- EP-A- 1 044 944
- EP-A- 1 479 657
- EP-A- 1 479 658
- EP-A- 1 479 659
- US-A1- 2002 098 391
- US-B1- 6 312 763

## Description

The present invention relates generally to protective coatings, especially protective coatings for use on gas turbine engine components.

Silicon carbide, silicon nitride, and other silica forming ceramics exhibit accelerated oxidation and recession in high temperature aqueous environments such as those found in combustor and turbine sections of gas turbine engines. It is believed that such material recession occurs because SiO₂ forming materials react with the water vapor at high temperatures, which leads to volatilization of the silica in the form of Si(OH)ₓ. Accordingly, protective coatings such as environmental barrier coatings (EBCs) may be used on components comprising such materials to slow the oxidation and recession and thereby increase the useful service life thereof.

While protective coatings have been developed for use on silicon carbide substrates, these coatings are not acceptable for use on certain monolithic silicon-containing substrates having lower coefficients of thermal expansion than silicon carbide (i.e., silicon nitride). Therefore, it would be desirable to have protective coatings that are capable of being used on silicon-containing substrates having lower coefficients of thermal expansion than silicon carbide. It would also be desirable to have protective coatings that have coefficients of thermal expansion that match those of the substrates they are used on, so as to create stable, crack-free structures. It would be further desirable to have protective coatings that inhibit the formation of volatile silicon species, particularly Si(OH)ₓ, in high temperature, aqueous environments. It would be yet further desirable to have protective coatings that provide thermal protection to the substrates they are used on. It would be even further desirable to have such protective coatings for use on silicon nitride substrates and/or on ceramic matrix composite substrates. It would be still further desirable to have improved methods for selecting suitable protective coatings for various substrates.

Furthermore, steam-stable, coefficient of thermal expansion compatible coatings for ceramic substrates often contain complex silicates, and the coating processes used to deposit these coatings on such substrates often result in amorphous phases and/or metastable phases in the coatings that subsequently change to equilibrium phases during or after use. Such changes may render the coatings unprotective, and therefore, undesirable. Therefore, it would be desirable to ensure that equilibrium phases exist in such coatings, prior to, during and after use, so that optimum protection is provided to the substrate.

US-A-2002/0098391 discloses a silicon nitride substrate which is coated with a rare earth silicate layer. The coating is deposited by chemical vapour deposition and is given a heat treatment at 1300-1800°C. US-B-6312763 and EP-A-1044944 both disclose a heat treatment step for a coating comprising 66-78 wt% Y₂O₃ balance SiO₂, which lasts 24 hours.

The above-identified shortcomings of existing protective coatings and methods of selecting same are overcome by embodiments of the present invention, which relates to protective coatings that can be used on various substrates such as silicon-containing substrates having lower coefficients of thermal expansion man silicon carbide. Adjusting the coating chemistry can result in coatings that are appropriate for use on both silicon carbide and silicon nitride substrates. These protective coatings may be utilized on various components, such as, but not limited to, gas turbine engine components.

According to the present invention, there is provided a method of making an article comprising thermal spraying a yttrium silicate coating on a silicon nitride substrate at a temperature of 1250-1300°C to create a coated substrate, wherein the yttrium silicate coating is a 36:64 mole ratio Y₂O₃-SiO₂ coating; and heat treating the coated substrate at 1250-1300 °C for 15-60 minutes prior to first cooling to create equilibrium phases of 1:1 and 1:2 mole ratio Y₂O₃-SiO₂ in the yttrium silicate coating.

The article may comprise a gas turbine engine component. In embodiments, the coating may comprise less than about 25 volume percent of non-equilibrium phases. In embodiments, the equilibrium phases are crystalline phases and comprise a 1:1 mole ratio rare-earth-oxide:silica, a 1:2 mole ratio rare-earth-oxide:silica, a rare earth oxide, silica and/or mixtures thereof. In embodiments, the coating may have a coefficient of thermal expansion within about +/- 1 ppm/°C of a coefficient of thermal expansion of the substrate.

The coating may comprise a yttrium monosilicate, a yttrium disilicate, a rare earth oxide, silica, and/or mixtures thereof. The coating may comprise a multi-layered protective coating system or a single layer graded protective coating system. The coating may be about 0.1-2000 microns thick.

The equilibrium phases may exist in the coating after the coating is deposited, but in accordance with the present invention, after the coating is deposited, and prior to first cooling, the article is heat treated to produce the equilibrium phases in the coating.

In embodiments, the article may further comprise a bond coat between the substrate and the coating, one or more intermediate layers between the bond coat and the coating, a topcoat disposed on the coating, and/or one or more intermediate layers between the coating and the topcoat.

Embodiments of this invention are described herein below with reference to various figures, wherein like characters of reference designate like parts throughout the drawings, in which:

Figure 1 is a schematic drawing showing a multiple layered coating system on a substrate, as utilized in embodiments of this invention;

Figure 2 is a schematic drawing showing a continuously graded coating system on a substrate, as utilized in embodiments of this invention;

Figure 3 is a graph showing the coefficient of thermal expansion of yttrium silicate as a function of the mole percent Y₂O₃ and SiO₂, as utilized in exemplary embodiments of this invention;

Figures 4 is a binary phase diagram showing the yttria-silica system utilized in exemplary embodiments of this invention;

Figure 5 is an x-ray diffraction pattern of a hot-pressed 36-64 mole percent Y₂O₃-SiO₂ solid body utilized to verify the desirability of a composition utilized in embodiments of this invention;

Figure 6 is an x-ray diffraction pattern of a 36-64 mole percent Y₂O₃-SiO₂ coating that was thermal sprayed onto a silicon nitride substrate at about 1090°C, then cooled, showing undesirable non-equilibrium phases and amorphous structure therein;

Figure 7 is an x-ray diffraction pattern of a 36-64 mole percent Y₂O₃-SiO₂ coating that was thermal sprayed onto a silicon nitride substrate at about 1090°C, and then heat treated at a temperature of about 1200°C for about 1 hour, showing that some of the undesirable amorphous structure converted to undesirable non-equilibrium crystalline phases; and

Figure 8 is an x-ray diffraction pattern of a 36-64 mole percent Y₂O₃-SiO₂ coating that was thermal sprayed onto a silicon nitride substrate at about 1300°C and held there for about 1 hour before first cooling, showing substantially only desirable equilibrium phases therein.

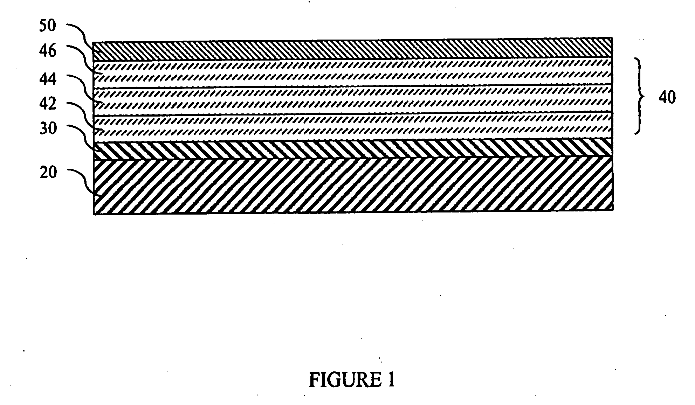

For the purposes of promoting an understanding of the invention, reference will now be made to some embodiments of this invention as illustrated in FIGURES 1-8 and specific language used to describe the same. The terminology used herein is for the purpose of description, not limitation. Specific structural and functional details disclosed herein are not to be interpreted as limiting, but merely as a basis for teaching one skilled in the art to variously employ the present invention. Any modifications or variations in the depicted structures and methods, and such further applications of the principles of the invention as illustrated herein, as would normally occur to one skilled in the art, are considered to be within the scope of this invention as described and claimed.

This invention relates to protective coatings that comprise substantially only specific equilibrium phases therein. These coatings have a coefficient of thermal expansion (CTE) that is substantially equal to the CTE of the substrate upon which the coatings are deposited. The desired phases and/or CTEs of these coatings can be obtained by controlling the application of these coatings and/or by heat treating the coated substrates to create the desired phases and/or microstructure in the coatings disposed thereon, as more fully described below. A difference of about +/- 1 ppm/°C in the CTE between the substrate and the coating will result in a strain of about 0.1 % over a temperature range of about 1000°C. The room temperature strain to failure for most brittle materials is about 0.1% in tension. Thus, a brittle ceramic coating will tend to crack on cooling if its CTE differs from that of the substrate by more than about 1 ppm/°C. Therefore, embodiments of these coatings have a CTE that is within about +/- 1 ppm/°C, more preferably within about +/- 0.3 ppm/°C, or even more preferably within about +/- 0.1 ppm/°C, of the CTE of the substrate the coating is used on.

As used herein and throughout, "equilibrium phases" and "equilibrium crystalline phases" refers: (1) to phases that do not change if they are heated to a temperature below the temperature at which they were processed at or quenched from (i.e., about 1500°C in some embodiments) for an amount of time similar to the expected, intended or actual useful life of the application; (2) to phases that, after fabrication/processing, do not change when exposed to expected, intended or actual application conditions; or (3) to phases that, even if they do change, do not affect the integrity of the coating (i.e., the phases before and after the change have equivalent thermal and physical properties). Trace amounts of impurities may be present in addition to the desired equilibrium phases.

These protective coatings may be used on various substrates as environmental barrier coatings, thermal barrier coatings, and/or as barriers that inhibit the formation of gaseous species of silicon, particularly, Si(OH)ₓ, when exposed to high temperature aqueous (i.e., water, steam) environments such as those found in gas turbine and combustion environments.

Embodiments of these protective coatings comprise any suitable material having the desired equilibrium phases and having a CTE that sufficiently matches that of the substrate. These protective coatings may also comprise minor amounts of impurities (i.e., less than about 10 volume percent) and/or dopants (i.e., less than about 5 volume percent).
In some embodiments, the CTE of the protective coating may be within +/- 1 ppm/°C of the CTE of the substrate.

In embodiments, these protective coatings may be utilized as part of a multi-layered protective coating system 40 on a substrate 20, with each layer 42, 44, 46 comprising a different CTE, as shown in one exemplary embodiment in Figure 1.

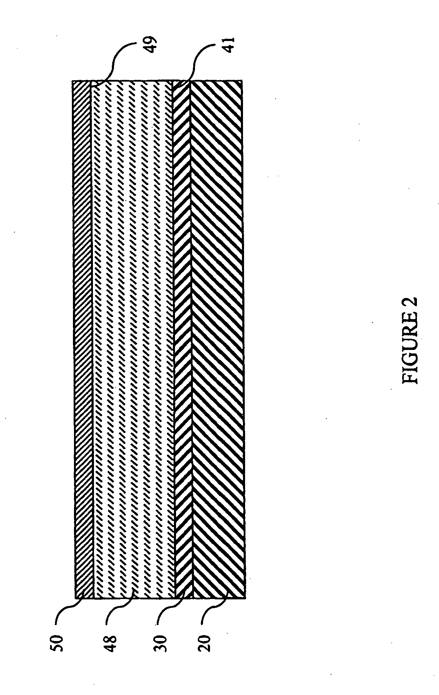

In other embodiments, these protective coatings may comprise a single graded protective coating layer 48 that has a graded composition from one surface to the other, as shown in one exemplary embodiment in Figure 2.

These protective coatings are applied to the substrate 20 by thermal spraying (i.e., air plasma spraying, low pressure plasma spraying, high velocity oxy-fuel spraying, combustion spraying, solution spraying etc.). These protective coatings are applied at a temperature that facilitates the creation of the desired equilibrium phases in the coatings. However these protective coatings are applied, the processing should result in a coating structure having very low stresses (i.e., comprising very low amounts of non-equilibrium phases that may subsequently convert to equilibrium phases and create stresses in the protective coating) so as to avoid cracking or spalling of the coating, etc.

In embodiments, a bond coat 30 may be disposed on the substrate 20. This bond coat 30 may comprise any suitable material, such as, for example, silicon, MoSi₂, a refractory metal silicide, a refractory metal, and other refractory metal oxide forming silicides, and/or combinations thereof, etc. These bond coats 30 may be applied to the substrate 20 in any suitable manner, such as, for example, by thermal spray, sputtering, chemical vapor deposition, physical vapor deposition, etc. These' bond coats 30 may be of any suitable thickness, and in embodiments, may be about 0.1-250 microns thick, more preferably about 0.5-100 microns thick, and even more preferably, about 1-50 microns thick. Bond coats 30 are typically used on silicon-containing substrates, but may not be needed on fiber reinforced oxide ceramic substrates.

In embodiments, a topcoat 50 may be disposed on the protective coating 40, 48. This topcoat 50 may comprise any suitable material, such as, for example, rare earth oxides, hafnium oxide, zirconium oxide, yttrium oxide, aluminum oxide, tantalum oxide, niobium oxide, mullite, alkaline earth aluminosilicates, barium aluminosilicates, strontium aluminosilicates, titanium oxide, silicon dioxide, rare earth phosphates, aluminium phosphates, and/or combinations thereof, etc. These topcoats 50 may be applied to the protective coating 40, 48 in any suitable manner, such as, for example, by thermal spraying, chemical vapor deposition, physical vapor deposition, electrophorectic deposition, electrostatic deposition, sol-gel, slurry coating, sputtering, dipping, spray painting, etc. These topcoats 40 may be of any suitable thickness, and in embodiments, may be about 1-250 microns thick, more preferably about 10-150 microns thick, and even more preferably, about 20-100 microns thick.

In embodiments, one or more intermediate layers (not shown) may be disposed either between the substrate 20 and the protective coating 40, 48, or between the protective coating 40, 48 and the topcoat 50. Such intermediate layers may provide enhanced adhesion between the substrate 20 and the protective coating 40, 48 and/or between the protective coating 40, 48 and the topcoat 50. Such intermediate layers may also prevent reactions between the substrate 20 and the protective coating 40, 48 and/or between the protective coating 40, 48 and the topcoat 50These intermediate layers may comprise any suitable materials, such as, for example, SiO₂, mullite, alkaline earth aluminosilicates, barium aluminosilicate, strontium aluminosilicate, barium strontium aluminosilicate, yttrium silicates, calcium aluminosilicate, silicon metal, rare earth oxides, hafnium oxide, zirconium oxide, titanium oxide, yttrium oxide, aluminum oxide, tantalum oxide, niobium oxide, rare earth phosphates, aluminium phosphates, and/or combinations thereof, etc. These intermediate layers may be applied in any suitable manner, such as, for example, by thermal spraying, chemical vapor deposition, physical vapor deposition, sol-gel, slurry coating, electrophoretic deposition, electrostatic deposition, sputtering, dipping, etc. These intermediate layers may be of any suitable thickness, and in embodiments, may be about 1-250 microns thick, more preferably about 10-150 microns thick, and even more preferably, about 20-100 microns thick.

The final coating should comprise less than about 25 volume percent, more preferably less than about 10 volume percent, and even more preferably less than about 1 volume percent, of non-equilibrium phases in the coating. In embodiments, substantially only equilibrium phases exist in the coating, but dopants (i.e., less than about 5 volume percent) and/or minor impurities (i.e., less than about 10 volume percent) may also be present.

### EXAMPLE

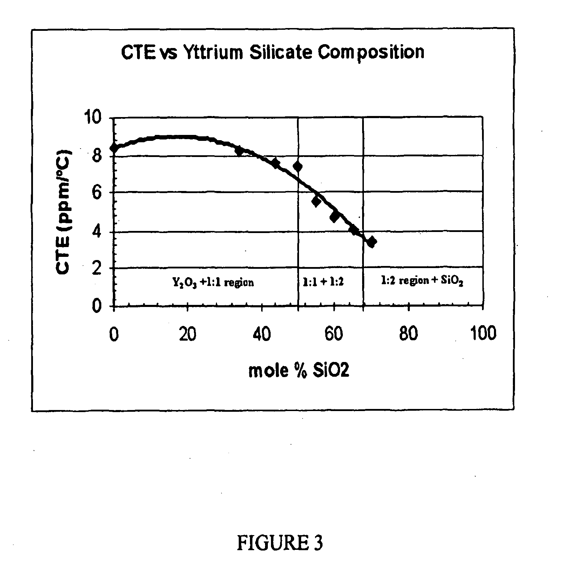

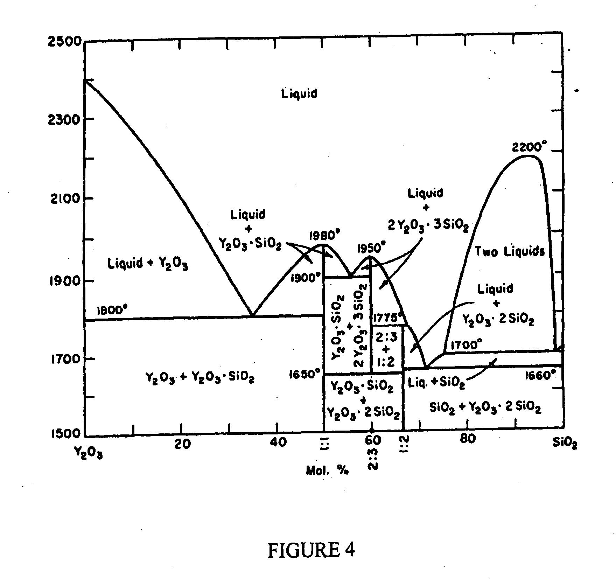

In one exemplary embodiment, a suitable yttrium silicate coating was identified for use on a silicon nitride substrate. Silicon nitride has a CTE of about 3.5 ppm/°C for room temperature to 1200°C. Since the CTE of yttrium silicate is generally determined by the ratio of yttria and silica present, and by the equilibrium phase content achieved by that ratio of yttria and silica, a yttrium silicate composition having a CTE close to that of the silicon nitride substrate can be selected by referring to Figure 3, where the effect of the yttria:silica ratio on the CTE of the yttrium silicate composition is shown. For example, as shown in Figure 3, if a CTE of about 4 ppm/°C is desired, a composition comprising about 62-66 mole percent silica (SiO₂), or alternatively stated, about 34-38 mole percent yttria (Y₂O₃), is desirable. The yttria-silica phase diagram shown in Figure 4 can be used to identify the equilibrium phases of yttria and silica that will be present at a given temperature in compositions comprising various mole percents of yttria and silica. When the techniques of this invention are followed to produce a thermodynamically equilibrated structure at room temperature, the phases shown in Figure 4 for the 1500°C isotherm are expected to exist at room temperature. Equilibrium crystalline phases are desired because any non-equilibrium crystalline and/or amorphous phases that are present may undergo phase transformations during subsequent processing or upon exposure to high operating temperatures, or they may exhibit CTEs other than those observed for equilibrium phases. Such phase changes may be accompanied by volume changes, which may lead to cracking and disruption of the coating, causing problems similar to the problems encountered when the CTEs of the coating and substrate are mismatched too much.

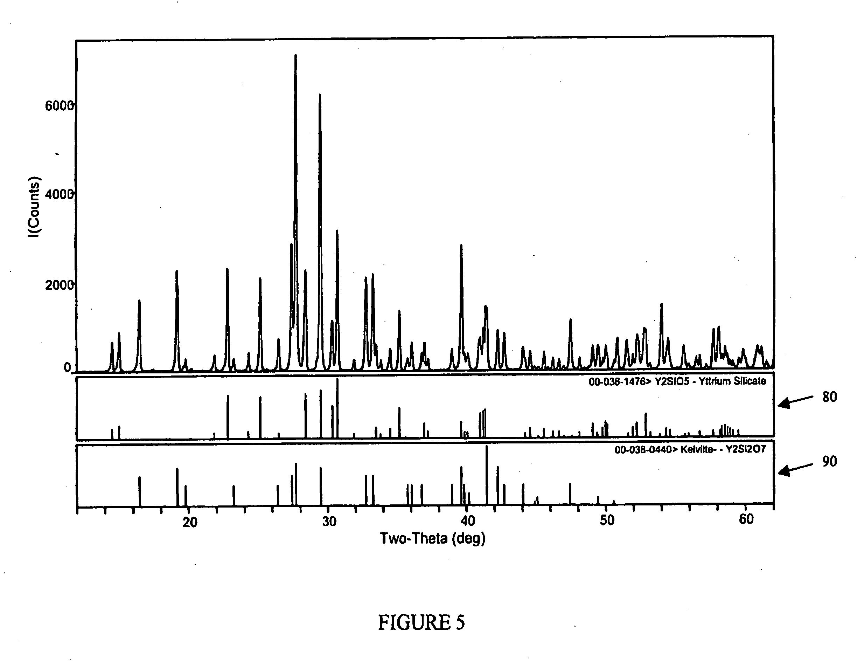

To determine if a 36-64 mole percent Y₂O₃-SiO₂ composition would indeed produce the desired phases in a coating on a silicon nitride substrate, an equilibrated solid body comprising about 36 mole percent Y₂O₃ and about 64 mole percent SiO₂ was fabricated by hot pressing. This solid body had the equilibrated structures indicated in Figure 5. As seen in the x-ray pattern in Figure 5, this body exhibited the desirable 1:1 and 1:2 mole ratio phases, 80 and 90 respectively, and had a CTE of about 4 ppm/°C, thereby verifying that the 36-64 mole percent Y₂O₃-SiO₂ composition would be desirable for use as a coating on silicon nitride substrates. This 36-64 mole percent Y₂O₃₋SiO₂ composition is also desirable because yttrium silicate exhibits good high temperature steam stability, and its CTE can be adjusted by altering the ratio of yttria and silica present.

Once this suitable 36:64 mole ratio Y₂O₃-SiO₂ composition was verified, a coating comprising the 36:64 mole ratio Y₂O₃₋SiO₂ composition was thermal sprayed via air plasma spray onto a silicon nitride substrate to create a coating about 20-150 microns thick. The following thermal spray parameters were used:

| Parameter | Setting |
|---|---|
| Gun | 3M |
| Nozzle | GH |
| Primary gas | Argon |
| Secondary gas | Hydrogen |
| Primary pressure (psi) | 40 |
| Secondary pressure (psi) | 0 |
| Current (amps) | 600 |
| Voltage (volts) | 50 |
| Powder port | #2∼80 mils |
| Carrier gas | Argon |
| Carrier feed (psi) | 40 |
| Feeder RPM | 3.85 |
| Powder feedrate (g/min) | 12 |
| Stand off (inches) | 4.75 |
| Spray temperature (°C) | 1300 |
| Cycles | 3 |
| Thickness (mils) | 4-5 |
| Gun speed (inches/second) | 6 |

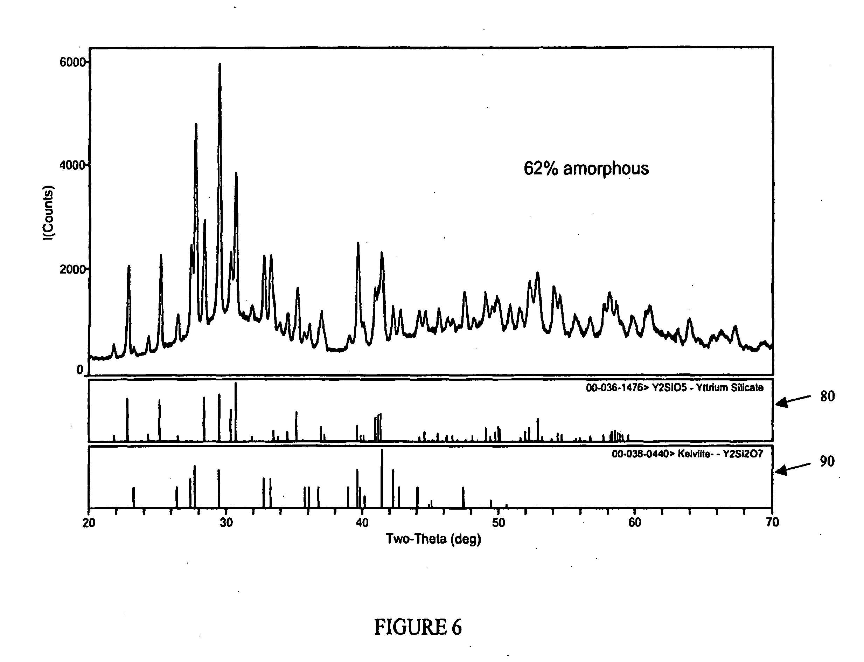

As shown in Figure 6, this coating exhibited both the 1:1 and 1:2 phases seen in Figure 5, 80 and 90 respectively, along with a substantial amount (about 62%) of amorphous structure that was not equilibrated. This amorphous phase content is undesirable and very deleterious to the coating integrity since it will exhibit a CTE different from the desired CTE, and will also undergo further phase change on subsequent thermal exposure, both of which will likely lead to cracking and spalling of the coating.

In order to achieve a thermal sprayed 36:64 mole ratio Y₂O₃-SiO₂ coating having the desired phases and CTE, certain critical conditions must be met during fabrication of the coating. Various attempts were made to determine these critical conditions, none of which required undue experimentation.

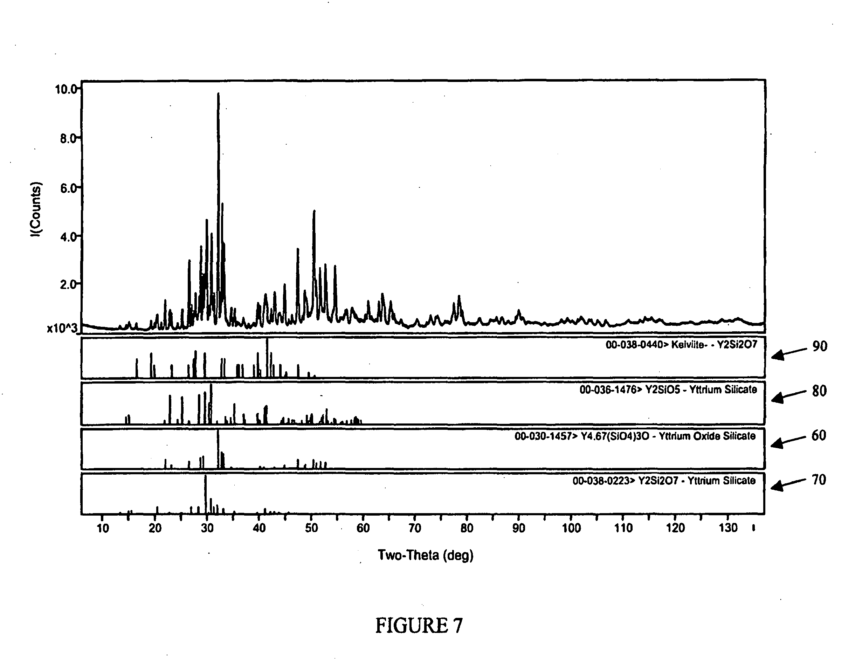

First, the 36:64 mole ratio Y₂O₃-SiO₂ coating was thermal sprayed via air plasma spray onto the silicon nitride substrate using the above-noted spray parameters, but spraying the coating onto the substrate at about 1200°C and holding the coated substrate at about 1200°C for about 1 hour before first cooling. Standard x-ray crystallography techniques were then used to identify and/or confirm which phases were present in the final coating. As shown in Figure 7, this method created a structure having the desirable 1:1 and 1:2 equilibrium phases present, 80 and 90 respectively, with no amorphous content, but also having undesirable non-equilibrium 7:9 and 1:2 mole ratio phases present, 60 and 70 respectively. Therefore, another attempt was made to eliminate these undesirable phases.

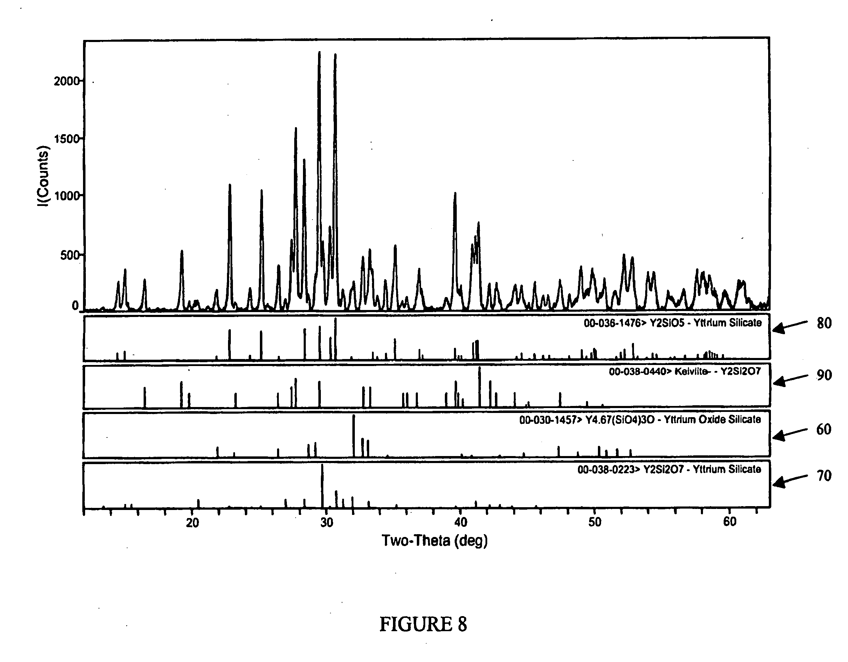

In that regard, a 36:64 mole ratio Y₂O₃-SiO₂ coating was thermal sprayed onto another silicon nitride substrate using the above-noted spray parameters, but this time spraying the coating onto the substrate at about 1300°C and holding the coated substrate at about 1300°C for about 1 hour before first cooling. As with the first attempt, standard x-ray crystallography techniques were then used to identify and/or confirm which phases were present in this final coating. As shown in Figure 8, this method created a structure having substantially only the desirable 1:1 and 1:2 equilibrium phases present, 80 and 90 respectively, with no amorphous content. As can also be seen in Figure 8, small amounts of the 7:9 mole ratio Y₂O₃-SiO₂ system 60, and variations of the 1:2 mole ratio Y₂O₃-SiO₂ system 70, were also present, but not in detrimental quantities.

These and other trial attempts indicated that this yttrium silicate coating should be deposited on the silicon nitride substrate at a temperature of about 1250-1300°C. They also indicated that this coated substrate should be heat treated at about 1250-1300°C for about 15-60 minutes, to obtain the desired equilibrium phases. They also indicated that heat treating this 36-64 mole percent Y₂O₃-SiO₂ coating/silicon nitride substrate system below about 1250°C is undesirable because a significant portion of the amorphous portion of the coating converts to the 7:9 mole ratio Y₂O₃-SiO₂ system 60, plus additional variations of the 1:2 mole ratio Y₂O₃-SiO₂ system 70, which creates an overall coating system of 1:1, 7:9 and variations of the 1:2 mole ratio Y₂O₃-SiO₂ systems, as shown in Figure 7. These 7:9 and variations of the 1:2 mole ratio Y₂O₃-SiO₂ systems, 60 and 70 respectively, are unstable, non-equilibrium phases that do not produce protective coatings that are suitable for use on silicon nitride. These 7:9 and variations of the 1:2 mole ratio Y₂O₃-SiO₂ systems, 60 and 70 respectively, when present in large amounts, result in cracked coatings being formed due to the mismatch between the CTEs of the coating and the substrate.

As described above, this invention provides protective coatings that have desired phases/microstructure therein. In embodiments, these protective coatings have a CTE within about +/-1 ppm/°C of the CTE of the substrate they are used on.

## Claims

1. A method of making an article comprising:
thermal spraying a yttrium silicate coating on a silicon nitride substrate at a temperature of 1250-1300°C to create a coated substrate, wherein the yttrium silicate coating is a 36:64 mole ratio Y₂O₃-SiO₂ coating; and
heat treating the coated substrate at 1250-1300 °C for 15-60 minutes prior to first cooling to create equilibrium phases of 1:1 and 1:2 mole ratio Y₂O₃-SiO₂ in the yttrium silicate coating.

2. A method as claimed in claim 1 wherein the yttrium silicate coating is thermal sprayed via air plasma spraying.

3. A method as claimed in claim 2 wherein the yttrium silicate coating is sprayed to a thickness of 20-150µm.

4. A method as claimed in claim 3, wherein the coated substrate is held at 1300°C for one hour before first cooling.

5. A method as claimed in any preceding claim, wherein the heat treatment results in the coating comprising less than 25 volume percent of non-equilibrium phases.

6. A method as claimed in claim 5, wherein the heat treatment results in the coating comprising less than 10 volume percent of non-equilibrium phases.

7. A method as claimed in any preceding claim, wherein the equilibrium phases are crystalline phases.

8. A method as claimed in any preceding claim, wherein the heat treatment results in the coating having a coefficient of thermal expansion within +/- 1 ppm/°C of a coefficient of thermal expansion of the substrate.

9. A method as claimed in any preceding claim further comprising at least one of:
applying a bond coat on the silicon nitride substrate prior to thermal spraying the yttrium silicate coating thereon;
applying at least one intermediate layer between the bond coat and the yttrium silicate coating:
applying a topcoat on the yttrium silicate coating prior to heat treating the coated substrate; and
applying at least one intermediate layer between the yttrium silicate coating and the topcoat.

10. A method as claimed in any preceding claim, wherein the article comprises a gas turbine engine component.

## Patentansprüche

1. Verfahren zur Herstellung eines Gegenstands aufweisend:
thermisches Spritzen einer Yttriumsilicat-Beschichtung auf ein Siliciumnitrid-Substrat bei einer Temperatur von 1250 bis 1300°C, um ein beschichtetes Substrat zu erzeugen, wobei die Yttriumsilicat-Beschichtung eine Y₂O₃-SiO₂-Beschichtung mit einem Mol-Verhältnis von 36:64 ist; und
Wärmebehandeln des beschichteten Substrats bei 1250 bis 1300°C für 15 bis 60 min vor dem ersten Abkühlen, um in der Yttriumsilicat-Beschichtung Gleichgewichtsphasen von Y₂O₃-SiO₂ mit einem Mol-Verhältnis von 1:1 1 und 1:2 zu erzeugen.

2. Verfahren wie in Anspruch 1 beansprucht, bei dem die Yttriumsilicat-Beschichtung mittels Luft-Plasmaspritzen thermisch gespritzt wird.

3. Verfahren wie in Anspruch 2 beansprucht, bei dem die Yttriumsilicat-Beschichtung in einer Dicke von 20 bis 150 µm aufgespritzt wird.

4. Verfahren wie in Anspruch 3 beansprucht, bei dem das beschichtete Substrat vor dem ersten Abkühlen eine Stunde lang bei 1300°C gehalten wird.

5. Verfahren wie in irgendeinem vorangehenden Anspruch beansprucht, bei dem die Wärmebehandlung dazu führt, dass die Beschichtung weniger als 25 Vol.-% an Nicht-Gleichgewichtsphasen aufweist.

6. Verfahren wie in Anspruch 5 beansprucht, bei dem die Wärmebehandlung dazu führt, dass die Beschichtung weniger als 10 Vol.-% an Nicht-Gleichgewichtsphasen aufweist.

7. Verfahren wie in irgendeinem vorangehenden Anspruch beansprucht, bei dem die Gleichgewichtsphasen kristalline Phasen sind.

8. Verfahren wie in irgendeinem vorangehenden Anspruch beansprucht, bei dem die Wärmebehandlung dazu führt, dass die Beschichtung einen Wärmeausdehnungskoeffizienten innerhalb von +/- 1 ppm/°C eines Wärmeausdehnungskoeffizienten des Substrats hat.

9. Verfahren wie in irgendeinem vorangehenden Anspruch beansprucht, außerdem mindestens einen der folgenden Schritte aufweisend:
Aufbringen einer Bindungsschicht auf das Siliciumnitrid-Substrat, bevor die Yttriumsilicat-Beschichtung darauf thermisch aufgespritzt wird;
Aufbringen mindestens einer Zwischenschicht zwischen der Bindungsschicht und der Yttriumsilicat-Beschichtung;
Aufbringen einer Deckschicht auf die Yttriumsilicat-Beschichtung vor der Wärmebehandlung des beschichteten Substrats; und
Aufbringen mindestens einer Zwischenschicht zwischen der Yttriumsilicat-Beschichtung und der Deckschicht.

10. Verfahren wie in irgendeinem vorangehenden Anspruch beansprucht, bei dem der Gegenstand eine Gasturbinenmaschinen-Komponente aufweist.

## Revendications

1. Procédé de fabrication d'un article comprenant :
la projection thermique d'un revêtement de silicate d'yttrium sur un substrat en nitrure de silicium à une température de 1250-1300°C pour créer un substrat revêtu, dans lequel le revêtement de silicate d'yttrium est un revêtement ayant un rapport en moles Y₂O₃-SiO₂ de 36:64 ; et
le traitement thermique du substrat revêtu à 1250-1300°C pendant 15-60 minutes avant un premier refroidissement pour créer des phases à l'équilibre ayant un rapport en moles Y₂O₃-SiO₂ de 1:1 1 et 1:2 dans le revêtement de silicate d'yttrium.

2. Procédé selon la revendication 1, dans lequel le revêtement de silicate d'yttrium est déposé par projection thermique par un procédé de projection plasma dans l'air.

3. Procédé selon la revendication 2, dans lequel le revêtement de silicate d'yttrium est projeté jusqu'à obtention d'une épaisseur de 20-150 µm.

4. Procédé selon la revendication 3, dans lequel le substrat revêtu est maintenu à 1300°C pendant une heure avant le premier refroidissement.

5. Procédé selon l'une quelconque des revendications précédentes, dans lequel le traitement thermique donne un revêtement comprenant moins de 25 % en volume de phases hors d'équilibre.

6. Procédé selon la revendication 5, dans lequel le traitement thermique donne un revêtement comprenant moins de 10 % en volume de phases hors d'équilibre.

7. Procédé selon l'une quelconque des revendications précédentes, dans lequel les phases à l'équilibre sont des phases cristallines.

8. Procédé selon l'une quelconque des revendications précédentes, dans lequel le traitement thermique confère au revêtement un coefficient de dilatation thermique dans les +/- 1 ppm/°C d'un coefficient de dilatation thermique du substrat.

9. Procédé selon l'une quelconque des revendications précédentes comprenant, en outre, au moins une des étapes suivantes:
l'application d'une couche de liaison sur le substrat en nitrure de silicium avant la projection thermique du revêtement de silicate d'yttrium sur celui-ci ;
l'application d'au moins une couche intermédiaire entre la couche de liaison et le revêtement de silicate d'yttrium ;
l'application d'une couche de protection sur le revêtement de silicate d'yttrium avant le traitement thermique du revêtement revêtu ; et
l'application d'au moins une couche intermédiaire entre le revêtement de silicate d'yttrium et la couche supérieure.

10. Procédé selon l'une quelconque des revendications précédentes, dans lequel l'article comprend un composant de moteur de turbine à gaz.
